**Europäisches Patentamt**

**European Patent Office**

**Office européen des brevets**

(11) Veröffentlichungsnummer: **0 247 502**
**B1**

(12) **EUROPÄISCHE PATENTSCHRIFT**

(45) Veröffentlichungstag der Patentschrift:
24.10.90

(51) Int. Cl.⁵: **H03K 19/177**

(21) Anmeldenummer: 87107285.6

(22) Anmeldetag: 19.05.87

(54) **Programmierbare Schaltungsanordnung.**

(30) Priorität: 30.05.86 DE 3618097

(43) Veröffentlichungstag der Anmeldung:
02.12.87 Patentblatt 87/49

(45) Bekanntmachung des Hinweises auf die Patenterteilung:
24.10.90 Patentblatt 90/43

(84) Benannte Vertragsstaaten:
AT DE FR GB IT NL

(56) Entgegenhaltungen:
EP-A- 0 096 225

IBM TECHNICAL DISCLOSURE BULLETIN, Band 18,
Nr. 3, August 1975, Seiten 820-822, New York, US; W.W.
WU: "Bidirectional switching array"
PATENT ABSTRACTS OF JAPAN, Band 9,
Nr. 302 (E-362)[2025], 29. November 1985; &
JP-A-60 139 023 (FUJITSU K.K.) 23-07-1985

(73) Patentinhaber: Siemens Aktiengesellschaft,
Wittelsbacherplatz 2, D-8000 München 2(DE)

(72) Erfinder: Gläser, Winfried, Hansjakobstrasse 125b,
D-8000 München 82(DE)
Erfinder: Schütt, Dieter, Prof.Dr., Dachsteinstr.26a,
D-8000 München 82(DE)

## Beschreibung

Die Erfindung bezieht sich auf eine programmierbare Schaltungsanordnung zur logischen Verknüpfung von binären Eingangssignalen unter Verwendung einer Matrix, die aus sich kreuzenden am einen Ende über jeweils einen Widerstand mit einer Betriebsspannungsquelle verbundenen ersten Leitungen und zweiten Leitungen und aus an Kreuzungsstellen zwischen den ersten und zweiten Leitungen angeordneten Verknüpfungseinheiten besteht.

Programmierbare Schaltungen, abgekürzt PLA, sind bekannt (siehe z.B. Weiß, Horninger, Integrierte MOS Schaltungen, Springer Verlag 1982, Seite 295 bis 298). Derartige programmierbare Schaltungen enthalten eine UND-Ebene und eine ODER-Ebene. In der UND-Ebene erfolgt die Verknüpfung der Eingangssignale entsprechend einer in der UND-Ebene gespeicherten Funktionstabelle. Die Verknüpfungsergebnisse der UND-Ebene, die auch Produktterme genannt werden, werden der ODER-Ebene zugeführt und dort entsprechend der in der ODER-Ebene enthaltenen Funktionstabelle zu den sog. Summentermen verknüpft. Die Summenterme werden an den Ausgängen der ODER-Ebene abgegeben. Ein derartiges PLA verfügt über Eingangsleitungen, die zu der UND-Ebene führen, und über Ausgangsleitungen, die aus der ODER-Ebene herausführen.

Die der Erfindung zugrundeliegende Aufgabe besteht darin, eine programmierbare Schaltungsanordnung derart aufzubauen, daß sie bidirektional betrieben werden kann; d.h. die in die programmierbare Schaltungsanordnung hineingehenden Leitungen können Eingangsleitungen oder Ausgangsleitungen sein.

Diese Aufgabe wird bei einer programmierbaren Schaltungsanordnung der eingangs angegebenen Art durch folgende Merkmale gelöst:
- je zwei erste Leitungen sind zu einem Leitungspaar zusammengefaßt,
- zur Realisierung einer logischen Verknüpfung ist jeweils eine bidirektional betreibbare Verknüpfungseinheit zwischen entweder der einen ersten Leitung oder der anderen ersten Leitung eines Leitungspaares und jeder der zweiten Leitungen angeordnet,
- am nicht mit der Betriebsspannungsquelle verbundenen Ende der einen ersten Leitung jedes Leitungspaares ist eine bidirektional betreibbare Treiberschaltung angeordnet,
- am nicht mit der Betriebsspannungsquelle verbundenen Ende der anderen ersten Leitung des Leitungspaares ist eine Treiberstufe angeordnet.

Die programmierbare Schaltungsanordnung besteht somit nicht mehr aus einer getrennt ausgeführten UND-Ebene und ODER-Ebene. Vielmehr besteht sie aus einer Matrix aus sich kreuzenden ersten und zweiten Leitungen und aus gemäß einer Funktionstabelle an den Kreuzungsstellen zwischen ersten und zweiten Leitungen angeordneten Verknüpfungseinheiten, die bidirektional betrieben werden können. Die ersten Leitungen können entsprechend der Einstellung der Verknüpfungseinheiten und der Treiberschaltung als Eingänge oder als Ausgänge verwendet werden. Werden erste Leitungen als Eingänge verwendet, dann werden die den Eingängen zugeführten Eingangssignalen, die über Verknüpfungseinheiten zu den zweiten Leitungen übertragen werden, auf den zweiten Leitungen einer UND-Verknüpfung unterworfen. Die ersten Leitungen, die durch entsprechende Schaltung der Verknüpfungseinheiten und der Treiberschaltung als Ausgänge verwendet werden, führen eine NOR-Verknüpfung der Signale durch, die über die Verknüpfungseinheiten von den zweiten Leitungen auf die ersten Leitungen übertragen worden sind.

Andere Weiterbildungen der Erfindung ergeben sich aus den abhängigen Ansprüchen.

Die programmierbare Schaltungsanordnung hat somit die Vorteile, daß logische Verknüpfungen von Eingangssignalen (im Gegensatz zu PLA's) unter Verwendung einer einzigen Matrix durchgeführt werden können und daß es möglich ist, die ersten Leitungen sowohl als Eingänge für die Eingangssignale als auch als Ausgänge für die Verknüpfungsergebnisse zu verwenden. Ein weiterer Vorteil der programmierbaren Schaltungsanordnung liegt darin, daß bei zusätzlicher Verwendung des Prüfungsnetzwerkes es weiterhin möglich ist, festzustellen, ob die an die Schaltungsanordnung angelegten Eingangsbitmuster nach der realisierten Funktionstabelle definiert sind oder nicht und ob ein durch Einstellung der Verknüpfungseinheiten festgelegter Ausgang ein richtiges Funktionsergebnis gemäß der Funktionstabelle abgibt oder nicht.

Anhand von Ausführungsbeispielen, die in den Figuren dargestellt sind, wird die Erfindung erläutert. Es zeigen

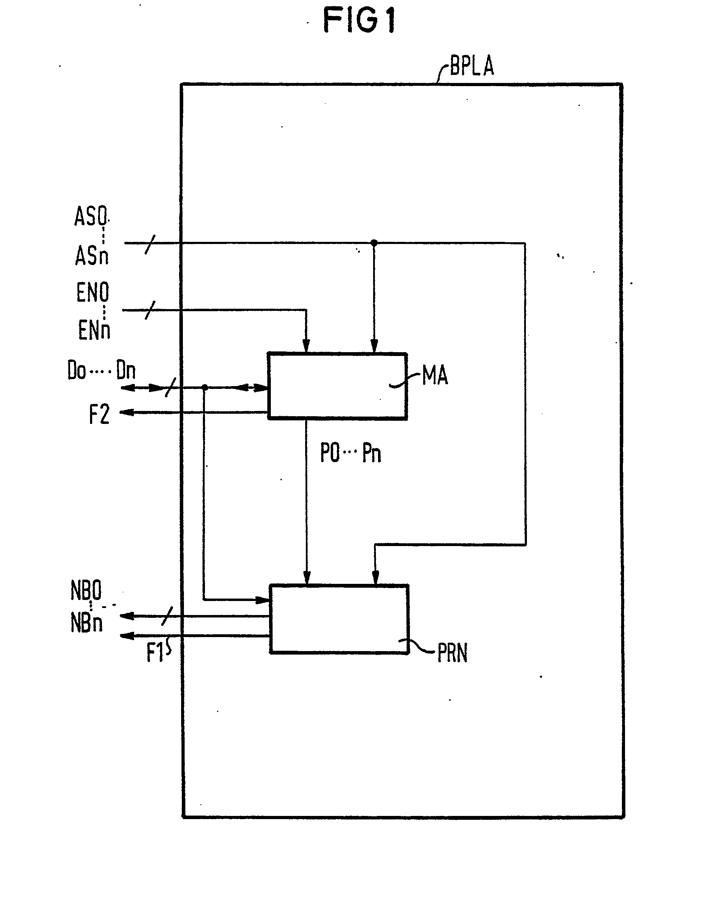

Fig. 1 ein Blockschaltbild der programmierbaren Schaltungsanordnung,

Fig. 2 eine Realisierung der Matrix der programmierbaren Schaltungsanordnung,

Fig. 3 eine erste Ausführungsform der Verknüpfungseinheit,

Fig. 4 eine zweite Ausführungsform der Verknüpfungseinheit,

Fig. 5 eine Schaltungsanordnung eines ersten Elementes der Verknüpfungseinheit,

Fig. 6 eine Schaltungsanordnung eines zweiten Elementes der Verknüpfungseinheit,

Fig. 7 eine prinzipielle Darstellung der Matrix, wenn die ersten Leitungen als Eingänge verwendet werden,

Fig. 8 eine prinzipielle Darstellung der Matrix, wenn die ersten Leitungen als Ausgänge verwendet werden,

Fig. 9 ein Beispiel für die Programmierung der Matrix,

Fig. 10 eine Schaltungsanordnung, mit der festgestellt werden kann, ob das an die Matrix angelegte Eingangsbitmuster in der in der Matrix gespeicherten Funktionstabelle enthalten ist,

Fig. 11 die Programmierung der Matrix, wenn diese als Addierer verwendet werden soll,

Fig. 12 und 13 zwei Beispiele, bei deren die als Addierer programmierte Matrix durch Einstellung von Verknüpfungseinheiten nicht gemäß der Funktionstabelle betrieben wird,

Fig. 14 eine Realisierung des Prüfnetzwerkes.

Die programmierbare Schaltung BPLA besteht aus einer Matrix MA und ggf. aus einem Prüfnetzwerk PRN. Die Matrix MA ist mit Datenleitungen D0 bis Dn verbunden, die bidirektional betrieben werden können. Mit Hilfe von zweiten Steuersignalen AS0 bis ASn wird festgelegt, ob die Datenleitungen D0 bis Dn als Ausgangsleitungen verwendet werden, mit Hilfe von ersten Steuersignale EN0 bis ENn wird festgelegt, ob die Datenleitungen D0 bis Dn als Eingangsleitungen verwendet werden. Die Matrix MA gibt weiterhin Prüfsignale P0 bis Pn ab, die zusammen mit den ersten Steuersignalen AS0 bis ASn und den Signalen auf den Datenleitungen D0 bis Dn dem Prüfnetzwerk PRN zugeführt werden. Durch Vergleich der Prüfsignale P0 bis Pn mit den auf den Datenleitungen D0 bis Dn auftretenden Signalen bei Verwendung der Datenleitungen als Ausgangsleitungen kann das Prüfnetzwerk PNN feststellen, ob die Matrix MA gemäß der in der Matrix gespeicherten Funktionstabelle verwendet wird. Die Bedeutung der Signale F1, F2, NB0 bis NBn ergibt sich aus der weiteren Beschreibung.

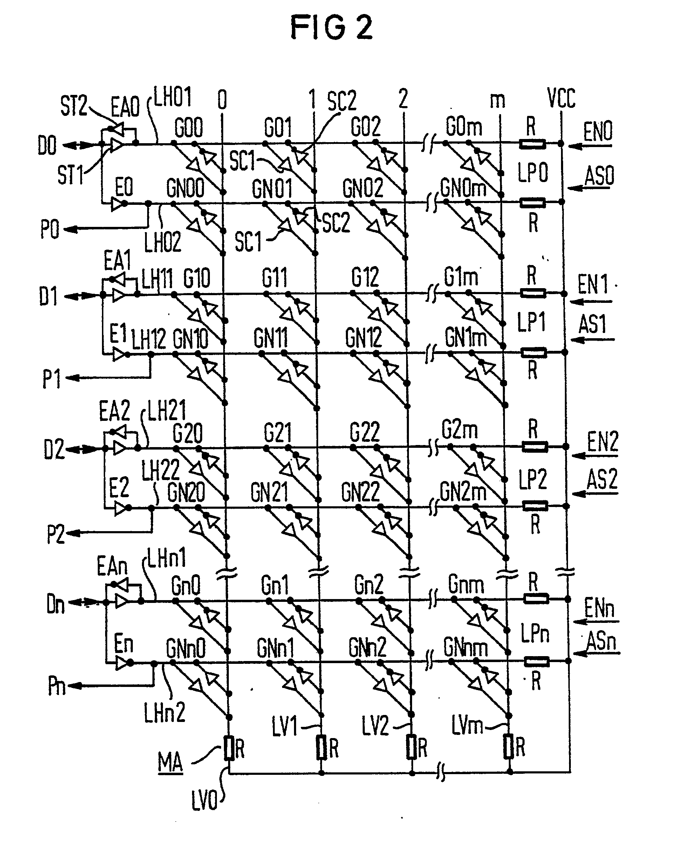

Eine vollständige Matrix, die noch nicht programmiert ist, ist in Fig. 2 dargestellt. Sie enthält erste Leitungen LH, zweite Leitungen LV, an den Kreuzungsstellen zwischen ersten Leitungen LH und zweiten Leitungen LV angeordneten Verknüpfungseinheiten G und GN, Treiberschaltungen EA und Treiberstufen E. Alle ersten Leitungen LH und alle zweiten Leitungen LV sind jeweils über einen Widerstand R mit einer Betriebsspannungsquelle VCC verbunden.

Jeweils zwei erste Leitungen LH sind zu einem Leitungspaar LP zusammengefaßt. Die Matrix MA enthält n+1 Leitungspaare LPn. Zwischen einer Datenleitung D und der einen ersten Leitung des zugeordneten Leitungspaares LP ist eine erste Treiberschaltung EA angeordnet, zwischen der Datenleitung D und der anderen ersten Leitung des Leitungspaares liegt eine Treiberstufe E. Zum Beispiel ist die Datenleitung D0 über die Treiberschaltung EA0 mit der einen ersten Leitung LH01 und über die Treiberstufe E0 mit der anderen ersten Leitung LH02 verbunden.

Im Beispiel der Fig. 2 sind m+1 zweite Leitungen LV0 bis LVm angeordnet. Zwischen den ersten Leitungen LH und den zweiten Leitungen LV liegen Verknüpfungseinheiten G,GN, die im Ausführungsbeispiel jeweils aus zwei Schaltelementen SC1 und SC2 bestehen. Mit Hilfe der ersten Steuersignale EN können die ersten Schaltelemente SC1 abgeschaltet werden, mit Hilfe der zweiten Steuersignale AS die Schaltelemente SC2. Im Ausführungsbeispiel der Fig. 2 sind die ersten Schaltelemente SC1 als nichtinvertierende Schaltelemente, die Schaltelemente SC2 als invertierende Schaltelemente dargestellt.

Alle Verknüpfungseinheiten sind gleich ausgeführt, jedoch sind die Verknüpfungseinheiten, die mit der ersten Leitung verbunden sind mit G, die Verknüpfungseinheiten, die mit der anderen ersten Leitung verbunden sind, mit GN benannt. Der Grund für diese verschiedene Benennung ergibt sich aus Fig. 9.

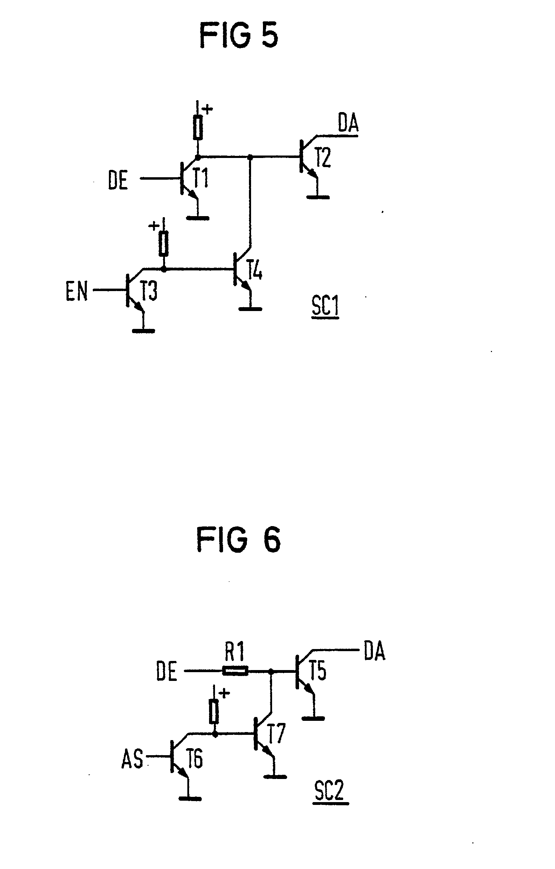

Eine Realisierung des ersten Schaltelementes SC1 kann Fig. 5 entnommen werden. Es besteht aus z.B.vier npn Transistoren T1 bis T4. Am Transistor T3 wird das erste Steuersignal EN angelegt. Liegt es vor, soll also das Schaltelement für Datensignale DE durchlässig sein, dann ist der Transistor T3 leitend gesteuert und der Transistor T4 gesperrt. Das Schaltelement wird somit durch das erste Steuersignal EN nicht beeinflußt. Ein Datensignal DE am Transistor T1 wird damit zum Ausgang DA übertragen. Der Transistor T2 ist in Open Kollektorschaltung realisiert. Wenn somit am Eingang DE eine binäre "0" liegt, dann ist der Transistor T2 leitend gesteuert und zieht die zugeordnete zweite Leitung LV auf "0" Potential. Liegt dagegen am Eingang DE eine binäre "1" an, dann ist der Transistor T2 gesperrt und das Potential auf der zugeordneten zweiten Leitung LV wird über das Schaltelement SC1 nicht beeinflußt. Ebenso wird das Potential auf der zugeordneten zweiten Leitung LV dann nicht beeinflußt, wenn das erste Steuersignal EN binär "0" ist und damit der Transistor T4 leitend gesteuert ist und der Transistor T2 gesperrt ist.

Eine Realisierung des zweiten Schaltelementes SC2 ergibt sich Fig. 6. Es besteht aus den Transistoren T5, T6, T7 und dem Widerstand R1. An den Transistor T6 wird das zweite Steuersignal AS angelegt. Ist dies der Fall, dann ist der Transistor T6 leitend gesteuert und damit der Transistor T7 gesperrt. Somit kann sich das Signal am Eingang DE über den Widerstand R1 am Transistor T5 auswirken. Ist das Signal am Eingang DE binär "1", dann ist der Transistor T5 leitend gesteuert und zieht das Potential auf der zugeordneten zweiten Leitung LV auf Masse oder "0" Potential. Ist das Signal am Eingang DE binär "0", dann bleibt der Transistor T5 gesperrt und das Potential auf der zugeordneten zweiten Leitung wird nicht beeinflußt. Ist das zweite Steuersignal AS binär "0", dann ist der Transistor T6 gesperrt, dagegen der Transistor T7 leitend gesteuert. Dies hat zur Folge, daß der Transistor T5 gesperrt ist und somit das Potential auf der zugeordneten zweiten Leitung LV nicht beeinflussen kann. Auch hier ist die Ausgangsstufe des Schaltelementes SC2 als Open Kollektorschaltung realisiert.

Die am Eingang jeder einen ersten Leitungen LH liegende Treiberschaltung ist entsprechend den Verknüpfungseinheiten G aufgebaut. Sie kann ebenfalls mit Hilfe der Steuersignale EN und AS geschaltet werden. Ist somit das erste Steuersignal EN binär "1", dann ist die Treiberstufe ST1 durchgeschaltet und die Treiberstufe ST2 gesperrt. Liegt dagegen das zweite Steuersignal AS an, dann ist die Treiberstufe ST2 betriebsfähig, die Treiberstufe ST1 dagegen gesperrt.

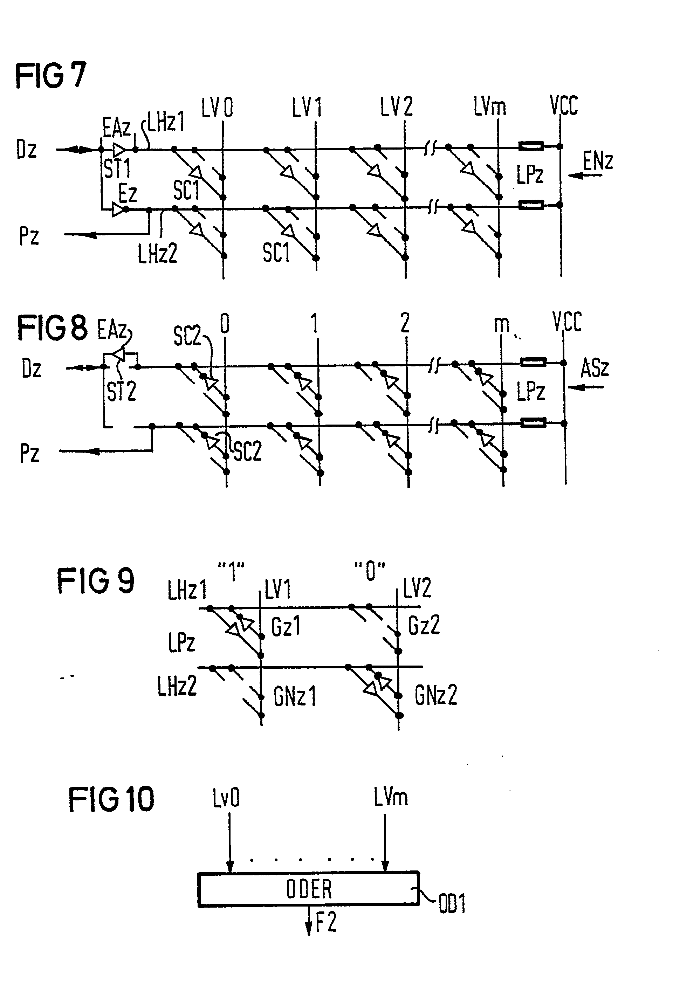

Fig. 7 zeigt, wie die Matrix elektrisch wirkt, wenn die ersten Leitungen LHz als Eingangsleitungen verwendet werden und somit Dz ein Eingang ist. In diesem Falle sind alle zweiten Schaltelemente SC2 als nicht vorhanden anzusehen und nur die ersten Schaltelemente SC1 wirksam. Ebenso ist die erste Treiberstufe ST1 der Treiberschaltung EAz wirksam, jedoch die zweite Treiberstufe ST2 nicht.

Fig. 8 zeigt den umgekehrten Fall. Hier ist Dz ein Ausgang. Dementsprechend liegt das zweite Steuersignal ASz an und jetzt sind die ersten Schaltelemente SC1 nicht wirksam, sondern die zweiten Schaltelemente SC2. Wirksam ist weiterhin die zweite Treiberstufe ST2 der Treiberschaltung EAz, nicht dagegen die Treiberstufe Ez.

Aus Fig. 9 ergibt sich, wie die Matrix entsprechend einer Funktionstabelle programmiert wird. Soll an einer Kreuzungsstelle zwischen dem Leitungspaar LPz und einer zweiten Leitung, z.B. LV1 eine binäre "1" programmiert werden, dann wird dazu die zwischen der einen ersten Leitung LHz1 und der zweiten Leitung LV1 liegende Verknüpfungseinheit Gz1 verwendet. Dagegen bleibt die zwischen der anderen ersten Leitung LHz2 und der zweiten Leitung LV1 liegende Verknüpfungseinheit GNz1 außer Funktion. Soll dagegen eine binäre "0" programmiert werden, z.B. zwischen dem Leitungspaar LPz und der zweiten Leitung LV2, dann ist die zwischen der einen ersten Leitung LHz1 und der zweiten Leitung LV2 angeordnete Verknüpfungseinheit Gz2 unwirksam, dagegen die zwischen der anderen ersten Leitung LHz2 und der zweiten Leitung LV2 liegende Verknüpfungseinheit GNz2 wirksam. Soll also eine binäre "1" an einer Kreuzungsstelle zwischen einem Leitungspaar LP und einer zweiten Leitung LV einprogrammiert werden, dann wird eine Verknüpfungseinheit G zwischen der einen ersten Leitung des Leitungspaares und der zweiten Leitung LV angeordnet, soll dagegen eine binäre "0" programmiert werden, dann wird zwischen der anderen ersten Leitung des Leitungspaares und der zweiten Leitung LV die Verknüpfungseinheit GN angeordnet. Die Verknüpfungseinheiten, die zur Programmierung der binären "1" vorgesehen sind, werden als G bezeichnet, diejenigen, die für die Programmierung der binären "0" verwendet werden, mit GN.

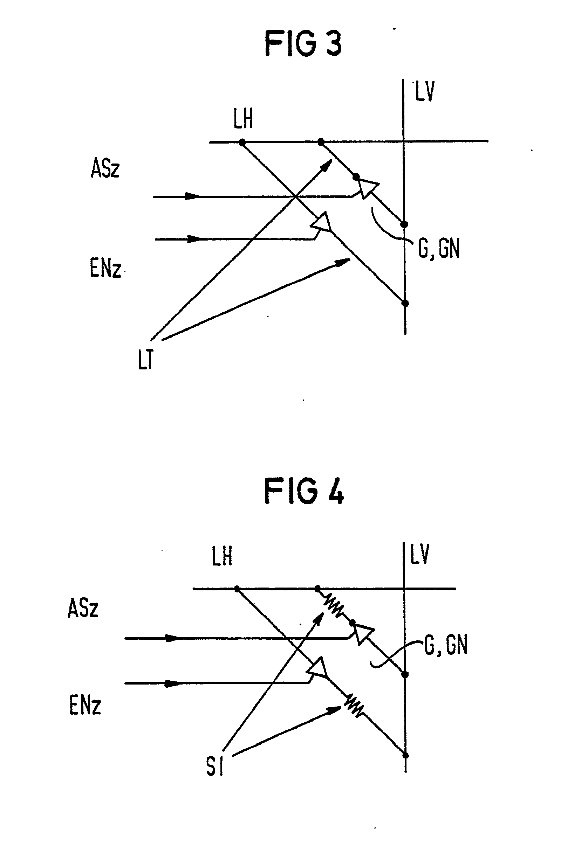

Die Programmierung der Verknüpfungseinheiten kann bei Realisierung in Gate Array Technik mit Hilfe von ein oder zwei Leitungsebenen LT durchgeführt werden. Es müssen dann jeweils die beiden Schaltelemente SC1 und SC2 verdrahtet sein oder nicht verdrahtet sein. Ein Beispiel dafür ist in Fig. 3 dargestellt. Die mit den Pfeilen angedeuteten Stellen der Verknüpfungseinheit G bzw. GN können vorhanden sein oder nicht vorhanden sein.

Eine weitere mögliche Realisierung der Programmierung mit Hilfe der Verknüpfungseinheiten kann gemäß Fig. 4 erfolgen. Hier sind zwischen jedem Schaltelement SC1, SC2 und einer zugeordneten ersten oder zweiten Leitung Sicherungen S1 eingefügt, die durchgetrennt werden können. Soll die Verknüpfungseinheit eine binäre "1" oder eine binäre "0" darstellen, dann sind die Sicherungen vorhanden, sonst sind sie durchgetrennt.

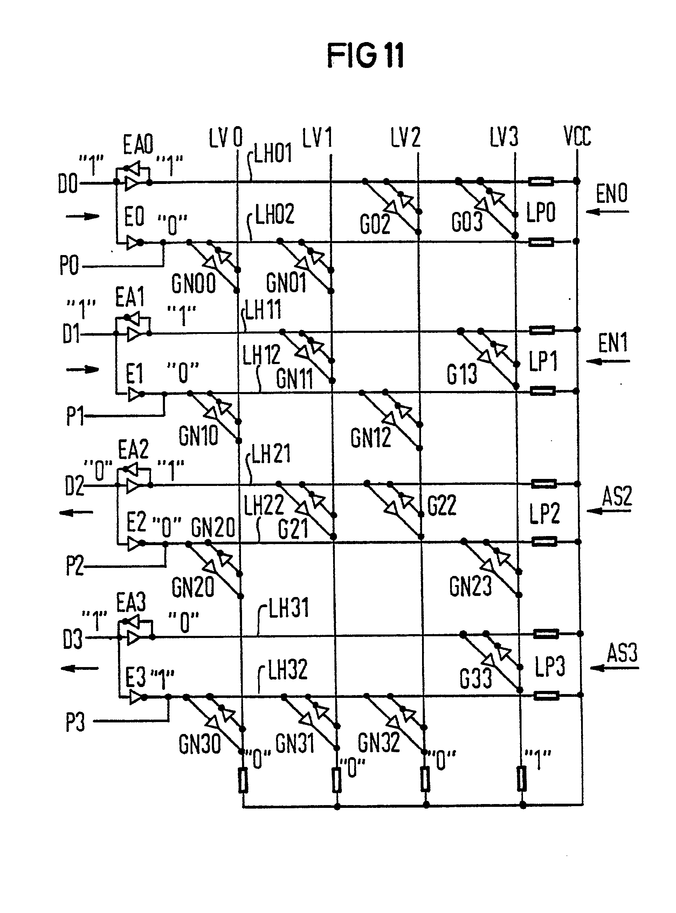

Die Programmierung der Matrix als Addierer ist in Fig. 11 dargestellt. Dabei wird davon ausgegangen, daß D0 und D1 Eingänge sind, D2 und D3 Ausgänge. Am Ausgang D2 wird der Wert für die Summe, am Ausgang D3 der Wert für den Überlauf abgegeben. Die Anordnung der Verknüpfungseinheit in der Matrix entspricht der Funktionstabelle, die bei einer Modulo-2-Addition von zwei Eingangswerten gegeben ist. Zum Beispiel zeigt die zweite Leitung LV0 in Verbindung mit den zugeordneten ersten Leitungen die Programmierung für D0 = "0" und D1 = "0". Dann ist die Summe D2 = "0" und der Übertrag D3 = "0". Oder die zweite Leitung LV3 zeigt die Verhältnisse, wenn an D0 und D1 eine binäre "1" anliegt. Dann ist die Summe am Ausgang D2 = "0" und der Übertrag am Ausgang D3 = "1". Die den zweiten Leitungen LV1 und LV2 zugeordneten Verknüpfungseinheiten entsprechen den beiden übrigen Kombinationsmöglichkeiten der Eingangssignale an den Eingängen D0 und D1 und die sich daraus ergebenden Ausgangssignale an dem Summenausgang D2 und Übertragsausgang D3.

Um D0 und D1 als Eingänge zu schalten, müssen die ersten Steuersignale EN0 und EN1 zugeführt werden. Bei den Leitungspaaren LP1 und LP2 zugeordneten Verknüpfungseinheiten sind somit die ersten Schaltelemente SC1 wirksam, dagegen die zweiten Schaltelemente SC2 nicht wirksam. Anders ist es bei den Ausgängen D2 und D3. Hier ist das zweite Steuersignal AS2 bzw. AS3 angelegt und somit beim Leitungspaar LP3 und LP2 jeweils die zweiten Schaltelemente SC2 wirksam, nicht dagegen die ersten Schaltelemente SC1. Von den Treiberschaltungen EA sind beim Leitungspaar LP0 und LP1 die Treiberstufen ST1, bei den Leitungsspaaren LP2 und LP3 die Treiberstufen ST2 wirksam.

Als Beispiel für die Funktion des Addierers nach Fig. 11 sei an die Eingänge D0 und D1 jeweils eine binäre "1" angelegt. Dann liegt auf der einen ersten Leitung LH01 und LH11 jeweils eine binäre "1", dagegen auf der anderen ersten Leitung LH02 und LH12 eine binäre "0". Da die ersten Steuersignale E0 und EN1 anliegen, sind bei den Leitungspaaren LP0 und LP1 nur die ersten Schaltelemente wirksam. Dementsprechend legt die Verknüpfungseinheit GN00 und GN01 an die zweiten Leitungen LV0 und LV1 eine binäre "0", ebenso die Verknüpfungseinheiten GN10 und GN12 eine binäre "0" an die zweite Leitung LV0 und LV2. An die zweite Leitung LV3 wird dagegen über die Verknüpfungseinheiten G03 und G13 eine binäre "1" angelegt. Es ist zu sehen, daß auf den zweiten Leitungen LV jeweils eine UND-Verknüpfung der den Eingängen D0 und D1 zugeführten binären Werten durchgeführt wird.

Die Leitungspaare LP2 und LP3 sind durch die zweiten Steuersignale AS2 und AS3 als Ausgänge wirksam. Dementsprechend sind die zweiten Schaltelemente wirksam, ebenso die zweite Treiberstufe ST2. Das binäre Signal "1" auf der zweiten Leitung LV3 legt über die Verknüpfungseinheit GN23 die Leitung LH22 und über die Verknüpfungseinheit G33 die Leitung LH31 auf binär "0". Die binäre "0" auf den zweiten Leitungen LV0, LV1, LV2 wirken über die Verknüpfungseinheiten G21, G22, GN30, GN31, GN32 auf die Leitungen LH21 und LH32 und erzeugen dort eine binäre "1". Jetzt ist zu sehen, daß auf den ersten Leitungen LH jeweils eine NOR-Verknüpfung der über die Verknüpfungseinheiten von den zweiten Leitungen LV eingekoppelten binären Werten erfolgt. Über die zweite invertierende Treiberstufe wird dann am Ausgang D2 und D3 der richtige Wert erhalten.

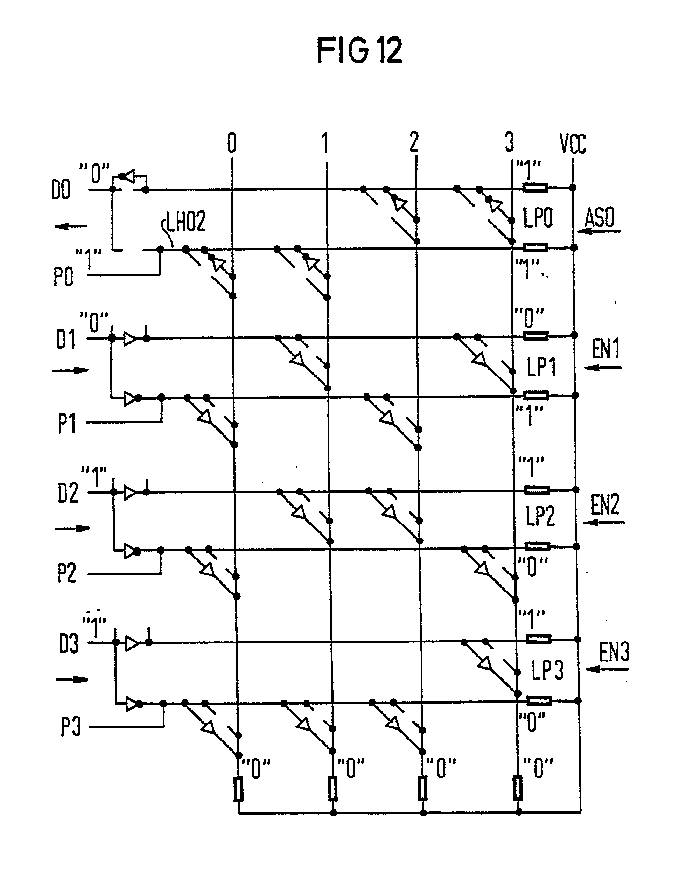

Fig. 12 zeigt die als Addierer programmierte Matrix, wenn D1, D2 und D3 als Eingänge und D0 als Ausgang geschaltet ist. Das bedeutet, daß das zweite Steuersignal AS0 und die ersten Steuersignale EN1, EN2 und EN3 anliegen. Zur Verdeutlichung der Funktion sind jeweils nur die Schaltelemente dargestellt, die aufgrund des Anliegens der Steuersignale AS0 und EN1, EN2, EN3 wirksam sind. Die anderen Schaltelemente, obwohl in Wirklichkeit vorhanden, sind nicht gezeigt. An den Eingängen D1, D2 und D3 werden die in Fig. 12 angegebenen binären Werte angelegt. Auf den zweiten Leitungen LV0 bis LV3 ergeben sich dann die in der Figur dargestellten binären Werte. Sie sind alle binär "0". Die als Ausgang geschalteten ersten Leitungen des Leitungspaares LP0 führen dann eine binäre "1". Am Ausgang D0 liegt nach Invertierung durch die invertierende Treiberstufe eine binäre "0" an. Die Leitungen LV0 bis LV3 sind binär "0". Es liegt ein nicht der Funktionstabelle entsprechender Betrieb der Matrix vor. Dieses wird mit der Schaltung in Fig. 10 festgestellt.

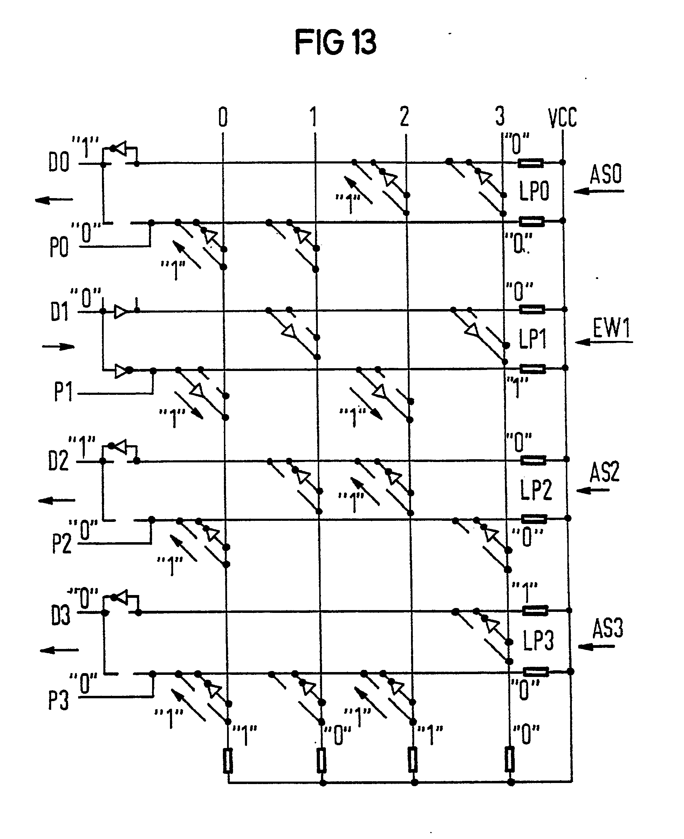

Bei Fig. 13 wird die als Addierer geschaltete Matrix mit D1 als Eingang und D0, D2, D3 als Ausgänge betrieben. Jetzt liegt das erste Steuersignal EN1 am Leitungspaar LP1, die zweiten Steuersignale AS0, AS2, AS3 an den Leitungspaaren LP0, LP2, LP3 an. Wiederum sind nur die Schaltelemente der Verknüpfungseinheiten gezeigt, die aufgrund der Steuersignale wirksam sind. Am Eingang D1 liege eine binäre "0" an. Dann ergibt sich auf den zweiten Leitungen LV0 bis LV3 die in Fig. 13 gezeigten binären Werte. Die Zurückkopplung dieser binären Werte auf das Leitungspaar LP0 ergibt, daß bei beiden ersten Leitungen eine binäre "0" auftritt. Dieser Ausgang D0 ist somit nicht bestimmbar. Entsprechendes gilt für das Leitungspaar LP2. Der zugeordnete Ausgang D2 ist ebenfalls nicht bestimmbar. Nur auf dem Leitungspaar LP3 tritt auf der einen Leitung eine binäre "1", auf der anderen Leitung eine binäre "0" auf. Dieses binäre Wertepaar entspricht der in der Matrix enthaltenen Funktionstabelle. Der Ausgang D3 ist somit bestimmbar.

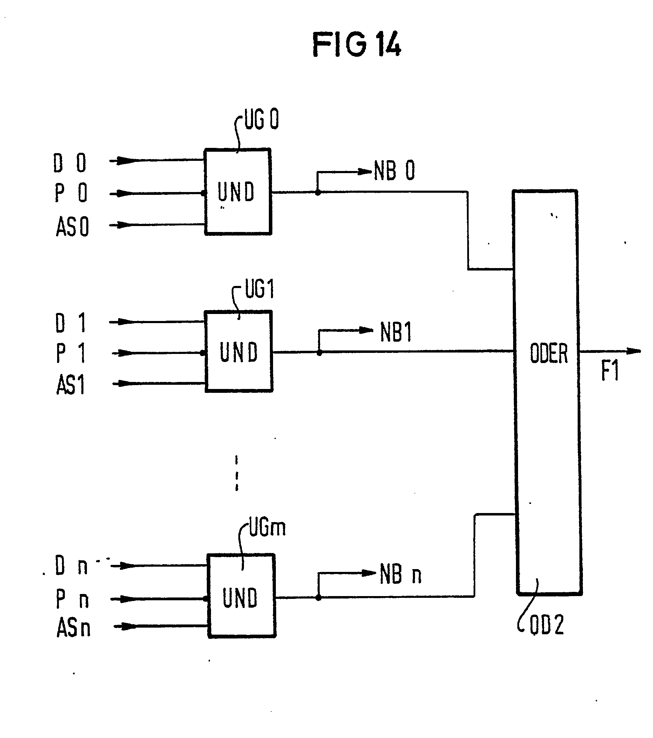

Durch Überprüfung der Werte an den Ausgängen D und den Prüfsignalen P mit Hilfe des Prüfnetzwerkes nach Fig. 14 kann festgestellt werden, welche der Leitungspaare bei Schaltung als Ausgang gleiche binäre Werte führen. Es wird festgestellt, daß die Ausgänge D0 unbd D2 nicht bestimmbar sind.

Eine Überprüfung der Funktion der Matrix kann mit Hilfe des Prüfnetzwerkes der Fig. 14 durchgeführt werden. Dazu wird jedem Leitungspaar LP0 bis LPn jeweils ein UND-Glied UG0 bis UGn zugeordnet. Jedem UND-Glied UG wird das Signal auf der Datenleitung D, das Prüfsignal P und das zweite Steuersignal AS zugeführt. Das UND-Glied gibt an seinem Ausgang ein Fehlersignal NB ab, wenn das Signal auf der Datenleitung D binär "1" das Prüfsignal P binär "0" sind. In diesem Falle ist dieser Ausgang nicht bestimmbar. Die Ausgangssignale der UND-Glieder UG0 bis UGn werden über ein ODER-Glied OD2 zu einem Fehlersignal F1 zusammengefaßt.

Mit Hilfe der ODER-Schaltung OD1 nach Fig. 10, durch die die zweiten Leitungen LV0 bis LVm zusammengefaßt werden, kann festgestellt werden, ob eine zweite Leitung den binären Wert "1" aufweist. Eine zweite Leitung führt den Wert binär "1", falls das an den Eingängen angelegte Eingangsbitmuster in der Funktionstabelle vorhanden ist. Daraus kann ein Signal F2 abgeleitet werden. Ist dieses Signal F2 "0", dann ist das angelegte Bitmuster in der Funktionstabelle nicht enthalten.

Mit der Matrix kann jede Art von logischen Funktionen realisiert werden. Erforderlich ist lediglich die Realisierung der dieser logischen Funktion zugrundeliegenden Funktionstabelle in der Matrix. Es ist weiterhin möglich, von einer fest programmierten Matrix auszugehen und durch Anlegen von ersten und zweiten Steuersignalen die Anzahl der Eingänge bzw. Ausgänge zu realisieren und die Ausgangswerte zu überprüfen.

Dabei ist es vorteilhaft, daß mit Hilfe des Prüfnetzwerkes ohne weiteres feststellbar ist, ob ein angelegtes Eingangsbitmuster zu einem bestimmbaren Ausgangswert führt oder nicht.

In den Ausführungsbeispielen sind die Verknüpfungseinheiten mit Hilfe von zwei Schaltelementen realisiert worden. Es ist auch möglich, die zwei Schaltelemente durch ein bidirektional betreibbares Schaltelement zu ersetzen.

## Patentansprüche

1. Programmierbare Schaltungsanordnung zur logischen Verknüpfung von binären Eingangssignalen unter Verwendung einer Matrix, die aus sich kreuzenden am einen Ende über jeweils einen Widerstand (R) mit einer Betriebsspannungsquelle (VCC) verbundenen ersten Leitungen (LH) und zweiten Leitungen (LV) und aus an Kreuzungsstellen zwischen den ersten und zweiten Leitungen (LH; LV) angeordneten Verknüpfungseinheiten (G, GN) besteht, gekennzeichnet durch folgende Merkmale:
-je zwei erste Leitungen (LH) sind zu einem Leitungspaar (LP) zusammengefaßt,
-zur Realisierung einer logischen Verknüpfung ist jeweils eine bidirektional betreibbare Verknüpfungseinheit (G, GN) zwischen entweder den einen ersten Leitung (Ln1) oder der anderen ersten Leitung (LHn2) eines Leitungspaares (LPn) und jeder der zweiten Leitungen (LV) angeordnet,
-am nicht mit der Betriebsspannungsquelle (VCC) verbundenen Ende der einen ersten Leitung (LHz1) jedes Leitungspaares ist eine bidirektional betreibbare Treiberschaltung (EA) angeordnet,
-am nicht mit der Betriebsspannungsquelle (VCC) verbundenen Ende der anderen ersten Leitung (LHz2) des Leitungspaares ist eine Treiberstufe (E) angeordnet.

2. Programmierbare Schaltungsanordnung nach Anspruch 1, dadurch gekennzeichnet, daß die Verknüpfungseinheit (G, Gn) aus zwei antiparallel geschalteten getrennt abschaltbaren Schaltelementen (SC1, SC2) besteht.

3. Programmierbare Schaltungsanordnung nach Anspruch 2, dadurch gekennzeichnet, daß das eine Schaltelement (SC1) der Verknüpfungseinheit (G, GN) nicht invertierend ausgeführt ist, das andere Schaltelement (SC2) invertierend.

4. Programmierbare Schaltung nach Anspruch 3, dadurch gekennzeichnet, daß die Treiberschaltung (EA) aus zwei antiparallel geschalteten getrennt abschaltbaren Treiberstufen (ST1, ST2) besteht.

5. Programmierbare Schaltung nach Anspruch 4, dadurch gekennzeichnet, daß die eine Treiberstufe (ST1) der Treiberschaltung nicht invertierend ausgeführt ist, die andere Treiberstufe (ST2) invertierend.

6. Programmierbare Schaltungsanordnung nach Anspruch 5, dadurch gekennzeichnet, daß bei Betrieb eines ersten Leitungpaares als Eingang die nicht invertierenden Treiberstufen (ST1) der Treiberschaltungen (EA) und die nicht invertierenden Schaltelemente (SC1) der Verknüpfungseinheiten (G, Gn) durchlässig geschaltet sind.

7. Programmierbare Schaltungsanordnung nach Anspruch 5, dadurch gekennzeichnet, daß bei Betrieb eines ersten Leitungspaares als Ausgang die invertierenden Treiberstufen (ST2) der Treiberschaltungen (EA) und die invertierenden Schaltelemente (SC2) der Verknüpfungseinheiten (G, GN) durchlässig geschaltet sind.

8. Programmierbare Schaltungsanordnung nach Anspruch 6, oder 7, dadurch gekennzeichnet, daß die Treiberstufe (E) in der anderen ersten Leitung (LHz2) jedes Leitungspaares invertierend ausgeführt ist und bei Schaltung eines Leitungspaares als Eingang durchlässig ist.

9. Programmierbare Schaltungsanordnung nach einem der vorhergehenden Ansprüche, dadurch gekennzeichnet, daß zwischen der einen ersten Leitung (LHz1) eines Leitungspaares (LPz) und einer zweiten Leitung (LV) dann eine Verknüpfungseinheit (G) angeordnet ist, wenn die diesem Leitungspaar zugeordnete Spalte der die logische Verknüpfung darstellenden Funktionstabelle an dieser Kreuzungsstelle einen ersten Binärwert ("1") vorschreibt, daß dagegen eine Verknüpfungseinheit (GN) zwischen der anderen ersten Leitung (LHz2) und einer zweiten Leitung (LVz) angeordnet ist, wenn die Funktionstabelle einen zweiten Binärwert ("0") vorschreibt.

10. Programmierbare Schaltungsanordnung nach Anspruch 9, dadurch gekennzeichnet, daß die Verknüpfungseinheiten (G,GN) so ausgeführt sind, daß die von den als Eingängen geschalteten ersten Leitungspaaren auf die zweiten Leitungen eingekoppelten binären Signale eine UND-Verknüpfung ausführen.

11. Programmierbare Schaltungsanordnung nach Anspruch 10, dadurch gekennzeichnet, daß die Verknüpfungseinheiten (G,GN) so ausgeführt sind, daß die von den zweiten Leitungen (LV) auf die als Ausgänge geschalteten ersten Leitungspaare eingekoppelten binären Signale auf den Leitungen dieses Leitungspaares eine NOR-Verknüpfung ausführen.

12. Programmierbare Schaltungsanordnung nach einem der Ansprüche 2 bis 11, dadurch gekennzeichnet, daß die Schaltelemente (SC) der Verknüpfungseinheiten als Ausgangsschaltung eine OPEN Kollektorausgangstransistorschaltung (T2, T5) enthalten, die bei nicht invertierenden Schaltelementen (SC1) leitend gesteuert sind, wenn der andere Binärwert ("0") anliegt, bei invertierendem Schaltelement (SC2) leitend gesteuert sind, wenn der eine Binärwert ("1") anliegt und die im leitenden Zustand die am Ausgang angeschlossene erste oder zweite Leitung auf ein festes Potential legen.

13. Programmierbare Schaltungsanordnung nach einem der Ansprüche 2 bis 12, dadurch gekennzeichnet, daß die Umschaltung der Schaltelemente (SC1, SC2) und der Treiberstufen (ST1, ST2) der Treiberschaltung von Steuersignalen (EN, AS) veranlaßt wird.

14. Programmierbare Schaltungsanordnung nach einem der vorhergehenden Ansprüche, dadurch gekennzeichnet, daß die zweiten Leitungen (LV) mit einer ODER-Schaltung (OD1) verbunden sind, die am Ausgang ein Signal (F2) abgibt, wenn das an die Matrix (MA) angelegte Eingangsbitmuster in der Funktionstabelle enthalten ist.

15. Programmierbare Schaltungsanordung nach einem der vorhergehenden Ansprüche, dadurch gekennzeichnet, daß ein Prüfnetzwerk (PRN) vorgesehen ist, das bei Betrieb eines Leitungspaares als Ausgang das auf der anderen ersten Leitung (LHz2) dieses Leitungspaares erzeugte Signal (P) mit dem am Ausgang (C) der einen ersten Leitung erzeugten Signal vergleicht.

16. Programmierbare Schaltungsanordnung nach Anspruch 15, dadurch gekennzeichnet, daß das Prüfnetzwerk (PRN) ein Fehlersignal (F1) erzeugt, wenn das Signal auf der einen ersten Leitung (C) binär "1" und das Signal auf der anderen ersten Leitung (P) binär "0" ist.

17. Programmiebare Schaltungsanordnung nach Anspruch 16, dadurch gekennzeichnet, daß im Prüfnetzwerk (PRN) jedem ersten Leitungspaar (LP) je eine UND-Schaltung (UG) zugeordnet ist.

## Revendications

1. Montage programmable pour réaliser la combinaison logique de signaux binaires d'entrée moyennant l'utilisation d'une matrice constituée par des premiers conducteurs (LH) et des seconds conducteurs (LV), qui se croisent et sont reliés, au niveau d'une extrémité, par l'intermédiaire d'une résistance respective (R), à une source de tension de service (VCC), et par des unités combinatoires (G, GN) disposées au niveau de points d'intersection entre les premiers et seconds conducteurs (LH; LV), caractérisé par les caractéristiques suivantes:

– deux premiers conducteurs (LH) sont respectivement réunis pour former un couple de conducteurs (LP),

– pour la réalisation d'une combinaison logique, une unité combinatoire (G, GN), qui peut fonctionner de façon bidirectionnelle, est disposée entre soit un premier conducteur (Ln1), soit l'autre premier conducteur (LHn2) d'un couple de conducteurs (LPn) et chacun des seconds conducteurs (LV),

– un circuit d'attaque (EA) pouvant fonctionner de façon bidirectionnelle est raccordé à l'extrémité, non reliée à la source de tension de service (VCC), du premier conducteur (LHz1),

– un étage d'attaque (E) est raccordé à l'extrémité, non reliée à la source de tension de service (VCC), de l'autre premier conducteur (LHz2).

2. Montage programmable suivant la revendication 1, caractérisé par le fait que l'unité combinatoire (G, Gn) est constituée de deux éléments de commutation (SC1, SC2), montés selon un montage antiparallèle et pouvant être placés séparément à l'état bloqué.

3. Montage programmable suivant la revendication 1, caractérisé par le fait qu'un élément de commutation (SC1) de l'unité combinatoire (G, GN) est réalisé de manière à ne pas réaliser d'inversion, et l'autre élément de commutation (SC2) est agencé de manière à réaliser une inversion.

4. Montage programmable suivant la revendication 3, caractérisé par le fait que le circuit d'attaque (EA) est constitué de deux étages d'attaque (ST1, ST2), branchés selon un montage antiparallèle et pouvant être placés séparément à l'état bloqué.

5. Montage programmable suivant la revendication 4, caractérisé par le fait qu'un étage d'attaque (ST1) du circuit d'attaque est agencé de manière à ne pas réaliser l'inversion et l'autre étage d'attaque (ST2) est agencé de manière à réaliser une inversion.

6. Montage programmable suivant la revendication 5, caractérisé par le fait que, dans le cas du fonctionnement d'un premier couple de conducteurs en tant qu'entrée, les étages d'attaque non inverseurs (ST1) des circuits d'attaque (EA) et les éléments de commutation non inverseurs (SC1) des unités combinatoires (G, GN) sont placés à l'état passant.

7. Montage programmable suivant la revendication 5, caractérisé par le fait que dans le cas du fonctionnement d'un premier couple de lignes en tant que sortie, les étages d'attaque inverseurs (ST2) des circuits d'attaque (EA) et les éléments de commutation inverseurs (SC2) des unités combinatoires (G, GN) sont placés à l'état passant.

8. Montage programmable suivant la revendication 6 ou 7, caractérisé par le fait que l'étage d'attaque (E) situé dans l'autre premier conducteur (LHz2) de chaque couple de conducteurs est agencé de manière à réaliser une inversion et, dans le cas du branchement d'un couple de conducteurs en tant qu'entrée, est passant.

9. Montage programmable suivant l'une des revendications précédentes, caractérisé par le fait qu'entre le premier conducteur (LHz) d'un couple de conducteurs (LPz) et un second conducteur (LV) est disposée une unité combinatoire (G) lorsque la colonne, associée à ce couple de conducteurs, de la table de fonctionnement représentant la combinaison logique prescrit, en ce point d'intersection, une première valeur binaire («1»), tandis qu'une unité combinatoire (GN) est disposée entre l'autre premier conducteur (LHz2) et un second conducteur (LVz) lorsque la table de fonctionnement prescrit une seconde valeur binaire («0»).

10. Montage programmable suivant la revendication 9, caractérisé par le fait que les unités combinatoires (G, GN) sont agencées de manière que les signaux binaires, injectés par couplage dans les seconds conducteurs par les premiers couples de conducteurs branchés en tant qu'entrées, réalisent une combinaison ET.

11. Montage programmable suivant la revendication 10, caractérisé par le fait que les unités combinatoires (G, GN) sont agencées de telle sorte que les signaux binaires injectés par couplage dans les seconds conducteurs (LV) dans les premiers couples de conducteurs branchés en tant que sorties, réalisent dans les conducteurs de ce couple de conducteurs une combinaison NON-OU.

12. Montage programmable suivant l'une des revendications 2 à 11, caractérisé par le fait que les éléments de commutation (SC) des unités combinatoires comportent, en tant que circuit de sortie, un circuit (T2, T5) à transistors de sortie à collecteur ouvert, qui sont placés à l'état conducteur dans le cas d'éléments de commutation (SC1) non inverseurs, lorsque l'autre valeur binaire («0») est appliquée, et sont placés à l'état conducteur dans le cas de l'élément de commutation inverseur (SC2), lorsque la première valeur binaire («1») est présente, et, à l'état conducteur, placent le premier ou le second conducteur raccordé à la sortie, à un potentiel fixe.

13. Montage programmable suivant l'une des revendications 2 à 12, caractérisé par le fait que la commutation des éléments de commutation (SC1, SC2) et des étages d'attaque (ST1, ST2) du circuit d'attaque est déclenchée par des signaux de commande (EN, AS).

14. Montage programmable suivant l'une des revendications précédentes, caractérisé par le fait que le second conducteur (LV) est relié à un circuit OU, (OD1), qui envoie à la sortie un signal (F2) lorsque le profil binaire d'entrée appliqué à la matrice (MA) est contenu dans la table de fonctionnement.

15. Montage programmable suivant l'une des revendications précédentes, caractérisé par le fait qu'il est prévu un réseau d'essai (PRN), qui, lors du fonctionnement d'un couple de conducteurs en tant que sortie, compare le signal (P), produit dans l'autre premier conducteur (LHz2) de ce couple de conducteurs, au signal produit sur la sortie (C) d'un premier conducteur.

16. Montage programmable suivant la revendication 15, caractérisé par le fait que le réseau d'essai (PRN) produit un signal d'erreur (F1) lorsque le signal est un «1» binaire dans le premier conducteur (C) et que le signal est un «0» binaire dans l'autre premier conducteur (P).

17. Montage programmable suivant la revendication 16, caractérisé par le fait que dans le réseau d'essai (PRN), à chaque premier couple de conducteurs (LP) est associé un circuit ET respectif (UG).

**Claims**

1. Programmable circuit for performing logic operations on binary input signals, using a matrix which is composed of crossed first lines (LH) and second lines (LV) which are connected at one end to an operating voltage source (VCC) in each case via a resistor (R), and of logic units (G, GN) arranged at the intersections between the first and second lines (LH; LV), characterized by the following features:

- two first lines (LH) are combined in each case to form one line pair (LP),
- for realizing a logic operation, in each case one bidirectionally operable logic unit (G, GN) is arranged between either the one first line (Ln1) or the other first line (LHn2) of a line pair (LPn) and each of the second lines (LV),
- a bidirectionally operable driver circuit (EA) is arranged at the end of a first line (LHz1) of each line pair which is not connected to the operating voltage source (VCC),
- a driver stage (E) is arranged at the end of the other first line (LHz2) of the line pair which is not connected to the operating voltage source (VCC).

2. Programmable circuit according to claim 1, characterized in that the logic unit (G, Gn) is composed of two switch elements (SC1, SC2) which are connected in anti-parallel fashion and are separately disconnectable.

3. Programmable circuit according to claim 2, characterized in that one switch element (SC1) of the logic unit (G, GN) is designed to be non-inverting, and the other switch element (SC2) to be inverting.

4. Programmable circuit according to claim 3, characterized in that the driver circuit (EA) is composed of two driver stages (ST1, ST2) which are connected in anti-parallel fashion and are separately disconnectable.

5. Programmable circuit according to claim 4, characterized in that one driver stage (ST1) of the driver circuit is designed to be non-inverting, and the other driver stage (ST2) to be inverting.

6. Programmable circuit according to claim 5, characterized in that when a first line pair is operated as an input, the non-inverting driver stages (ST1) of the driver circuits (EA) and the non-inverting switch elements (SC1) of the logic units (G, GN) are switched to be conductive.

7. Programmable circuit according to claim 5, characterized in that when a first line pair is operated as an output, the inverting driver stages (ST2) of the driver circuits (EA) and the inverting switch elements (SC2) of the logic units (G, GN) are switched to be conductive.

8. Programmable circuit according to claim 6 or 7, characterized in that the driver stage (E) in the other first line (LHz2) of each line pair is designed to be inverting and is conductive when one line pair is switched as an input.

9. Programmable circuit according to one of the preceding claims, characterized in that a logic unit (G) is arranged between one first line (LHz1) of a line pair (LPz) and a second line (LV) whenever the column, associated with this line pair, of the function table representing the logic operation prescribes a first binary value ("1") at this intersection, and in that on the other hand a logic unit (GN) is arranged between the other first line (LHz2) and a second line (LVz) when the function table prescribes a second binary value ("0").

10. Programmable circuit according to claim 9, characterized in that the logic units (G, GN) are designed in such a way that the binary signals coupled onto the second lines from the first line pairs switched as inputs execute a logical AND operation.

11. Programmable circuit according to claim 10, characterized in that the logic units (G, GN) are designed in such a way that the binary signals coupled from the second linea (LV) onto the first line pairs switched as outputs execute a logical NOR operation on the lines of said line pair.

12. Programmable circuit according to one of claims 2 to 11, characterized in that the switch elements (SC) of the logic units contain as output circuit an OPEN collector output transistor circuit (T2, T5), which are activated, in the case of non-inverting switch elements which (SC1), when the other binary value ("0") is applied, which are activated in the case of an inverting switch element (SC2) when the one binary value ("1") is applied and which in the conductive state connect the first or second line connected to the outpt to a fixed potential.

13. Programmable circuit according to one of claims 2 to 12, characterized in that the switchover of the switch elements (SC1, SC2) and the driver stages (ST1, ST2) of the driver circuit is initiated by control signals (EN, AS).

14. Programmable circuit according to one of the preceding claims, characterized in that the second lines (LV) are connected to an OR circuit (OD1) which outputs a signal (F2) at the output when the function table contains the input bit pattern applied to the matrix (MA).

15. Programmable circuit according to one of the preceding claims, characterized in that a testing network (PRN) is provided which, when a line pair is operated as an output, compares the signal (P) generated on the other first line (LHz2) of this line pair with the signal generated at the output (C) of the one first line.

16. Programmable circuit according to claim 15, characterized in that the testing network (PRN) generates an error signal (F1) when the signal on the one first line (C) is binary "1" and the signal on the other first line (P) is binary "0".

17. Programmable circuit according to claim 16, characterized in that in each case one AND circuit (UG) is associated with each first line pair (LP) in the testing network (PRN).

# FIG 1

# FIG 2

# FIG 3

# FIG 4

# FIG 5

# FIG 6

# FIG 7

# FIG 8

# FIG 9

# FIG 10

## FIG 11

# FIG 12

FIG 13

# FIG 14